# FASCICULE DE BREVET EUROPEEN

(11) **EP 4 227 742 B1**
(45) Date de publication et mention de la délivrance du brevet: **13.11.2024**
(21) Numéro de dépôt: 23156117.6
(22) Date de dépôt: 10.02.2023
(51) Int. Cl.: G04B 1/14, B81C 1/00, G04B 13/02, G04B 15/14, G04B 17/06, G04B 19/04, B81C 99/00

(54) **PROCÉDÉ DE FABRICATION D'UNE PIÈCE EN SILICIUM**
VERFAHREN ZUR HERSTELLUNG EINES SILIZIUMBAUTEILS
METHOD FOR MANUFACTURING A SILICON PART

(30) Priorité: 11.02.2022 CH 1312022
(43) Date de publication de la demande: 16.08.2023
(73) Titulaire: Sigatec SA, 1950 Sion (CH)
(72) Inventeur: Clivaz, Johannes, 1958 Uvrier (CH); Tille, Nicolas, 1965 Savièse (CH); Glassey, Marc-André, 1967 Bramois (CH)
(74) Mandataire: BOVARD AG

(56) Documents cités:
- CH-A2- 714 815
- JP-A- 2017 044 533
- US-B1- 6 287 885

## Description

### Domaine technique de l'invention

La présente invention concerne la fabrication de pièces en silicium, en particulier de composants horlogers tels que des spiraux, ancres, roues d'échappement, roues dentées, plateaux, aiguilles, balanciers.

### État de la technique

Les composants horlogers en silicium sont typiquement fabriqués à l'aide d'un substrat - aussi appelé wafer - de type silicium sur isolant connu sous l'acronyme SOI (silicon on insulator). Un tel substrat comprend une première couche de silicium dans laquelle les composants doivent être formés, une deuxième couche de silicium servant à rigidifier le substrat et, entre ces deux couches de silicium, une couche intermédiaire de dioxyde de silicium servant de couche d'arrêt pour les opérations de gravure de la première couche.

Selon une méthode connue, la première couche de silicium est gravée afin d'y former les pièces à fabriquer d'une part et une rainure entourant lesdites pièces d'autre part. Une plaquette délimitée par la rainure et portant les pièces gravées est ensuite détachée du substrat pour être soumise généralement à des opérations d'oxydation et désoxydation visant à améliorer l'état de surface des pièces, ajuster leur raideur, et/ou augmenter leur résistance mécanique, avant qu'elles ne soient finalement détachées de la plaquette.

Ce procédé pose plusieurs problèmes. Mise à haute température, notamment dans un four d'oxydation thermique, la plaquette a tendance à fléchir sous l'effet de son propre poids. Sous l'effet de cette déformation, les composants peuvent être détériorés, voire se détacher, ce qui les rend inutilisables pour leur fonction première. Par ailleurs, les déformations de la plaquette sont permanentes et irréversibles, ce qui exclut également son utilisation dans d'autres équipements par exemple des équipements de mesure de la raideur de spiraux.

On connaît déjà, par exemple de la demande EP 3 543 795, un procédé de fabrication dans lequel la plaquette est supportée par une plaque de support et retournée entre chaque opération d'oxydation-désoxydation, de façon à empêcher ou au moins limiter les effets de déformation de la plaquette et donc des composants.

Mais le montage de la plaquette sur la plaque de support, de même que les opérations de retournements successifs, sont longs et fastidieux.

Du document JP 2017 044533, on connaît aussi un procédé dans lequel la deuxième couche d'un substrat de type SOI est gravée en regard d'un composant formé dans la première couche de façon à conserver une section de support.

### Résumé de l'invention

La présente invention vise à proposer un procédé de fabrication permettant de surmonter les inconvénients de l'art antérieur précités.

Selon l'invention, ce but est atteint grâce à l'objet des revendications indépendantes. Les aspects plus spécifiques de la présente invention sont décrits dans les revendications dépendantes ainsi que dans la description.

Plus spécifiquement, ce but est atteint avec un procédé de fabrication d'au moins une pièce en silicium, dans lequel
a) on fournit un substrat comprenant la superposition, dans une direction transversale, d'au moins une première couche de silicium d'épaisseur e1, une couche intermédiaire de dioxyde de silicium, et une deuxième couche de silicium d'épaisseur e2, la couche intermédiaire étant ainsi interposée entre la première et la deuxième couche ;
puis, dans cet ordre ou un autre :
b) on grave la première couche pour y former l'au moins une pièce,
c) dans la deuxième couche, on grave au moins une rainure de détachement pour délimiter au sein de ladite deuxième couche au moins une portion à détacher recouvrant ou destinée à recouvrir ladite au moins une pièce, au moins une portion dite portion borgne de la rainure de détachement étant gravée de sorte qu'une partie de la deuxième couche, formant lien, soit conservée au droit de ladite portion,
d) on retire partiellement la couche intermédiaire en éliminant le dioxyde de silicium au droit de ladite au moins une portion à détacher ou de l'emplacement prévisionnel de ladite portion à détacher ;
   et enfin
e) on sépare mécaniquement l'au moins une portion à détacher du reste du substrat en brisant le lien.

Le procédé selon l'invention comprend ainsi la réalisation d'une rainure de détachement dans la deuxième couche du substrat, pour permettre le détachement d'une portion de cette deuxième couche et ainsi la libération d'au moins une portion utile de la première couche, située en regard de ladite portion à détacher, et portant une ou plusieurs pièces.

Le substrat modifié obtenu à l'issue des étapes a) à e) comprend au moins une partie renforcée ou cadre, formée par la superposition d'une partie de la première couche et d'une portion résiduelle de la deuxième couche, liées par une partie de couche intermédiaire.

Pour assurer la conservation d'un tel cadre, l'étape d) est stoppée après élimination complète de la couche intermédiaire au droit de la ou les portions à détacher mais avant élimination de la totalité de la couche intermédiaire.

Le substrat modifié obtenu par le procédé de l'invention peut ainsi être soumis aux mêmes traitements ultérieurs que la plaquette de l'art antérieur. Mais son cadre lui confère une rigidité suffisante pour qu'il ne se déforme pas ou dans une moindre mesure, lors de ces opérations.

La conservation, selon l'invention, d'au moins un lien au droit de la rainure de détachement permet de dissocier les étapes de retrait partiel de la couche intermédiaire et de détachement effectif de la partie à détacher. L'opération de retrait du dioxyde de silicium peut ainsi être réalisée quelle que soit l'orientation du substrat, sans risquer de choc entre les pièces et la portion à détacher. Le lien rend par ailleurs optionnelle la tenue de la portion à détacher, par exemple par vacuum ou moyens électrostatiques, ce qui permet de simplifier la machine utilisée pour la séparation.

Dans la présente demande, un lien est donc une partie de la deuxième couche délimitée entre le fond de la rainure de détachement, gravée dans la deuxième couche, et le plan d'interface entre ladite deuxième couche et la couche intermédiaire. Un lien forme typiquement une bande, un ruban, une membrane s'étendant dans le plan du substrat et dont l'épaisseur, constante ou variable, est strictement inférieure à l'épaisseur totale de ladite deuxième couche.

Dans la suite, on appelle portion utile chaque zone de la première couche comprenant une ou plusieurs pièces et libérée après détachement d'une portion à détacher.

On désigne par ailleurs par groupe de pièces un ensemble de pièces faisant face à une même portion à détacher.

Un substrat est généralement utilisé pour la fabrication d'une pluralité de pièces, identiques ou différentes.

Selon un exemple, on grave une pluralité de pièces dans la première couche, et au moins une rainure de détachement dans la deuxième couche délimite une portion à détacher recouvrant ou destinée à recouvrir ladite pluralité de pièces.

Selon un exemple, la rainure de détachement délimite, à elle seule ou conjointement avec un chant du substrat, un contour fermé.

Chaque portion à détacher est généralement une portion pleine, c'est-à-dire non gravée à l'intérieur du contour fermé qu'elle délimite (seule ou avec le chant du substrat).

Selon un exemple, la rainure de détachement longe le chant du substrat, à une distance variable ou constante de celui-ci, typiquement supérieure à 5mm.

Dans ce cas notamment, au moins une partie du cadre borde le chant du substrat.

Avantageusement, l'étape d) peut être stoppée de sorte qu'une largeur de la portion de couche intermédiaire entre la première couche et la portion résiduelle de la deuxième couche reste au moins localement, de préférence en tout point, supérieure à 1mm. De cette façon, la largeur reste suffisante pour maintenir l'adhésion entre les deux couches.

Selon un exemple, une largeur de la rainure de détachement, mesurée orthogonalement à la direction transversale, est inférieure ou égale à 500 microns et avantageusement supérieure à 50 microns.

Selon un exemple, lors de l'étape e), on pousse la partie à détacher par l'intermédiaire d'au moins un outil introduit à travers une rainure gravée dans la première couche à l'étape b).

Avantageusement, l'épaisseur d'un lien est inférieure à la largeur de la rainure de détachement.

Selon un exemple, l'épaisseur d'un lien, mesurée dans la direction transversale, est égale à au moins 2 microns, et de préférence inférieure à 50 microns.

L'épaisseur d'un lien peut être constante sur toute la longueur du lien.

Dans certains modes de réalisation, toutefois, l'épaisseur d'un lien peut aussi ne pas être constante sur sa longueur.

Selon un exemple, la rainure de détachement est gravée de sorte qu'un lien est conservé au droit de ladite rainure sur toute sa longueur. La rainure de détachement est alors borgne sur toute sa longueur. Autrement dit, la rainure de détachement s'étend sur une épaisseur de la deuxième couche strictement inférieure à e2 sur toute sa longueur.

Selon un autre exemple, la rainure de détachement comporte en outre au moins une portion traversante sur laquelle elle traverse toute l'épaisseur e2 de la deuxième couche.

Selon un exemple, la rainure de détachement comporte une alternance de portions traversantes sur lesquelles elle traverse toute l'épaisseur e2 de la deuxième couche et de portions borgnes. En particulier, à l'issue des étapes b), c) et d), la portion à détacher peut être liée à la portion résiduelle de la deuxième couche par une pluralité d'éléments de liaisons espacées l'une de l'autre, de préférence régulièrement réparties sur toute la longueur de la rainure de détachement.

Selon un exemple, les étapes b), c), d) sont réalisées dans cet ordre.

Selon un autre exemple, les étapes c), b), d) sont réalisées dans cet ordre.

Dans ces deux cas, on forme la ou les pièces à fabriquer dans la première couche puis on grave la ou les rainures de détachement, ou inversement, puis seulement on procède à l'élimination partielle de la couche intermédiaire. Dans de telles configurations, à l'étape d), la couche intermédiaire est partiellement éliminée sur une zone couvrant la totalité de la portion à détacher de la deuxième couche, délimitée par la rainure préalablement réalisée à l'étape c).

Selon encore un autre exemple de réalisation, les étapes b), d), c) sont réalisées dans cet ordre.

Dans ce cas, on forme d'abord la ou les pièces à fabriquer dans la première couche, puis on élimine partiellement la couche intermédiaire sur au moins une première zone située au droit de l'emplacement prévisionnel de la portion à détacher, avant de procéder à la gravure de la rainure de détachement. Sur toute sa longueur, la rainure de détachement est alors formée au droit d'une zone de la couche intermédiaire sur laquelle le dioxyde de silicium a d'ores et déjà été éliminé.

D'autres exemples plus spécifiques du procédé selon l'invention sont encore décrits ci-dessous :
- A l'étape d), l'élimination partielle de la couche intermédiaire peut être réalisée par gravure chimique.
- Dans le cas d'une gravure chimique, l'étape d) peut mettre en oeuvre au moins un agent décapant, généralement en phase vapeur, configuré pour ronger progressivement le dioxyde de silicium de la couche intermédiaire, sans attaquer le silicium de la première et la deuxième couche. La gravure peut être avantageusement une gravure à la vapeur d'acide fluorhydrique.
- Afin d'éviter ou limiter les phénomènes de condensation qui pourraient entraver la gravure chimique, le substrat peut être chauffé pendant l'étape d).
- L'élimination de la couche intermédiaire peut être faite par gravure chimique à l'étape d), et l'agent décapant peut être dirigé vers la première couche du substrat lors de ladite gravure.
- Lors de l'étape d), la rainure de détachement du substrat peut être au moins partiellement, de préférence totalement, protégée contre la gravure.
- Plus généralement, lors de l'étape d), la deuxième couche et/ou un chant du substrat peu(ven)t être au moins partiellement recouvert d'une protection contre la gravure chimique, de façon à retarder l'élimination du dioxyde de silicium de la couche intermédiaire sous la portion résiduelle de la deuxième couche.
- Par exemple, dans une étrape d0) préalable à l'étape d), une couche de matériau protecteur, par exemple une couche de résine résistante à la gravure chimique, peut être déposée sur la deuxième couche et/ou sur le chant du substrat, et/ou un couvercle, par exemple sous la forme d'une plaque de recouvrement, peut être fixé sur le substrat pour protéger la deuxième couche et/ou son chant.
- A l'issue de l'étape d), la portion de couche intermédiaire restante est soit continue, soit non-continue mais présente en plusieurs endroits répartis régulièrement ou non.
- Plusieurs rainures de détachement peuvent être gravées à l'étape c), avec chaque portion à détacher délimitée par une rainure recouvrant ou étant destinée à recouvrir une ou plusieurs pièces formées dans la première couche.
- Au moins une portion à détacher peut recouvrir une pluralité de pièces formées dans la première couche.
- Une unique portion à détacher peut recouvrir au moins la moitié, de préférence l'ensemble, des pièces formées dans le substrat.
- La portion résiduelle peut former un cadre en périphérie du substrat, ledit cadre s'étendant de manière continue sur au moins 30% de la périphérie du substrat, de préférence sur au moins 50% de la périphérie du substrat.
- La portion à détacher peut recouvrir au moins 30 % de la surface du substrat, de préférence au moins 50% de la surface du substrat.
- Lors de la formation de chaque pièce dans la première couche, au moins une rainure primaire est généralement gravée, laquelle correspond à un bord externe de ladite pièce à l'exception d'une portion non gravée ou attache (conservée pour assurer la liaison entre la pièce et le reste de la première couche) et le cas échéant au moins une rainure primaire interne de profil correspondant à un bord interne de ladite pièce.
- A l'étape b), au moins une rainure périphérique peut en outre être gravée autour de ladite au moins une rainure primaire, la au moins une rainure primaire et la rainure périphérique délimitant un espace de débattement de ladite pièce à l'issue de l'étape d). L'espace de débattement permet, à la fin du procédé, de mouvoir la pièce pour rompre plus facilement l'attache et ainsi détacher la pièce.
- la gravure de l'étape b) et/ou l'étape c) peut être une gravure ionique réactive profonde.
- la gravure de l'étape b) et/ou c) peut être réalisée à travers un masque de résine photosensible.
- l'étape b) peut comprendre au moins les sous-étapes suivantes :
   b1) recouvrir la première couche d'une couche (primaire) de résine photosensible,
   b2) par photolithographie, former dans ladite couche primaire de résine au moins une ouverture (primaire) correspondant à un contour de au moins une pièce,
   b3) graver la première couche sur toute son épaisseur sous ladite au moins une ouverture (primaire) pour former la pièce.
- L'étape b) peut comprendre, après l'étape b3), une étape b4) au cours de laquelle la couche primaire de résine est éliminée, notamment par nettoyage au plasma d'oxygène.
- l'étape c) peut comprendre au moins les sous-étapes suivantes :
   c1) recouvrir la deuxième couche d'une couche (secondaire) de résine photosensible,
   c2) par photolithographie, former dans ladite couche secondaire de résine au moins une ouverture (secondaire) correspondant au profil de la rainure de détachement,
   c3) graver la deuxième couche sous la dite au moins une ouverture (secondaire).
- L'étape c) peut comprendre, après l'étape c3), une étape c4) au cours de laquelle la couche secondaire de résine est éliminée, notamment par nettoyage au plasma d'oxygène.
- Le procédé peut comprendre, préalablement aux étapes b) et/ou c), une étape a', respectivement a", dans laquelle on oxyde le substrat, par exemple en faisant croître une couche de dioxyde de silicium à la surface du substrat. Dans ce cas, la couche est gravée dans les ouvertures de la résine, notamment par gravure au plasma, dans une étape b2', respectivement c2', préalable à l'étape b3, respectivement c3.
- Dans un mode de mise en oeuvre dans lequel l'étape d) est réalisée préalablement à l'étape c), le procédé peut notamment comprendre, après l'étape d) et avant l'étape c), une étape a") d'oxydation du substrat, notamment par croissance, sur le substrat, d'une couche de dioxyde de silicium destinée à former une couche d'arrêt pour la gravure de la rainure de détachement. Une telle couche de protection peut notamment avoir une épaisseur inférieure à 2 microns.
- Le procédé peut comprendre, après l'étape b), de préférence après les étapes a), b), c) et d), encore plus préférentiellement après l'étape e), au moins une étape f) d'oxydation, ou d'oxydation et désoxydation du substrat, visant notamment à lisser et/ou ajuster les dimensions de chaque pièce.
- Le procédé peut comprendre, après les étapes a) à d), de préférence après l'étape e) et éventuellement après l'étape f), au moins une étape g) d'oxydation, ou d'oxydation et de désoxydation du substrat modifié, en vue d'ajuster la raideur ou les dimensions de chaque pièce.
- Le procédé peut comprendre, après les étapes a) à d), de préférence après l'étape e) et notamment après l'étape f) et/ou g), une étape h) d'oxydation du substrat modifié, à des fins de thermocompensation ou de renforcement mécanique de chaque pièce.
- Le procédé peut comprendre, après l'étape e), de préférence après les étapes g) et/ou h), une étape i) de détachement de chaque pièce, notamment par rupture de l'attache la maintenant au substrat (et en particulier au reste de la première couche).

### Brève description des dessins

Les particularités et les avantages de la présente invention apparaîtront avec plus de détails dans le cadre de la description qui suit donnée à titre illustratif et non limitatif en référence aux dessins ci-annexés:
Les figures 1A à 1S illustrent schématiquement les étapes du procédé selon un mode de mise en oeuvre de l'invention correspondant à la séquence d'étapes de la figure 8.
La figure 2 est une vue de dessus d'un substrat à l'issue des étapes a), b) et c) du procédé, montrant la première couche du substrat (et en pointillé la rainure de détachement).
La figure 3 est une vue de détail de la zone III identifiée sur la figure 2.
La figure 4A illustre un motif d'un masque de gravure d'une rainure de détachement de profondeur constante.
La figure 4B illustre un motif d'un masque de gravure d'une rainure de détachement formée d'une alternance de portions de profondeurs différentes.
La figure 5 illustre un substrat muni d'une rainure de détachement comportant au moins une portion borgne et une portion traversante,
La figure 6 illustre un substrat à l'issue des étapes b), c) et d), dans un cas où le chant du substrat n'a pas été protégé contre la gravure chimique.
La figure 7 est une vue de dessus d'un substrat obtenu selon une variante de mise en oeuvre du procédé, dans laquelle plusieurs rainures de détachement sont gravées à l'étape c).
La figure 8 est un digramme illustrant la succession des étapes du procédé selon le premier mode de mise en oeuvre.
La figure 9 est un diagramme illustrant la succession des étapes du procédé selon un deuxième mode de mise en oeuvre.
La figure 10 est un diagramme illustrant la succession des étapes du procédé selon un troisième mode de mise en oeuvre.
Les figures 11A à 11Q illustrent schématiquement les étapes du procédé selon le troisième mode de mise en oeuvre de l'invention correspondant à la séquence d'étapes de la figure 10.

### Description détaillée

Les figures annexées illustrent différents modes de mise en oeuvre du procédé selon l'invention pour la fabrication de pièces telles que des roues d'échappement. Tout autre type de pièce en silicium, notamment des spiraux, ancres, roues dentées, plateaux, aiguilles, balanciers, pourra bien sûr être réalisé de façon similaire. L'enchaînement des étapes selon les modes de mise en oeuvre décrits en détail dans la suite n'est pas limitatif de l'invention, et certaines étapes pourront être interverties et/ou répétées sans sortir du cadre de l'invention.

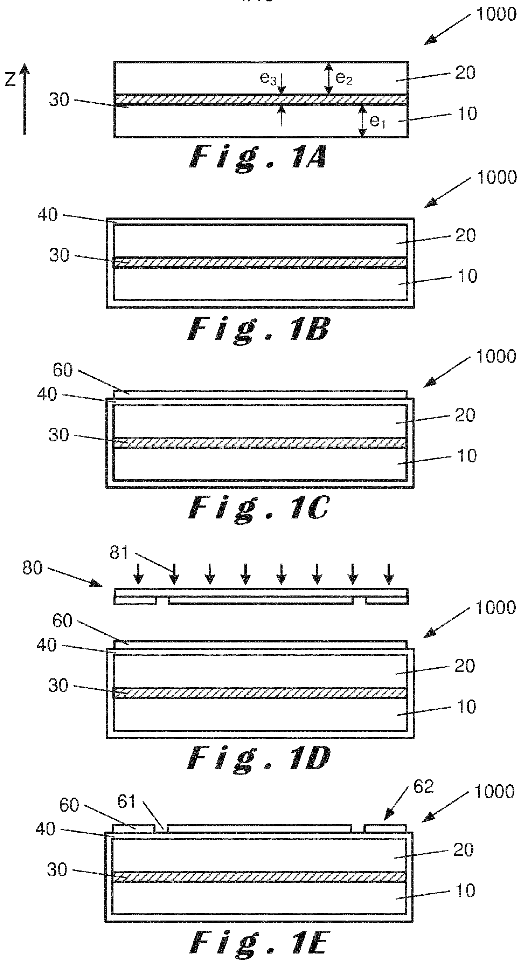

Un premier mode de mise en oeuvre de la présente invention va être décrit ci-après en référence aux figures 1A à 1S.

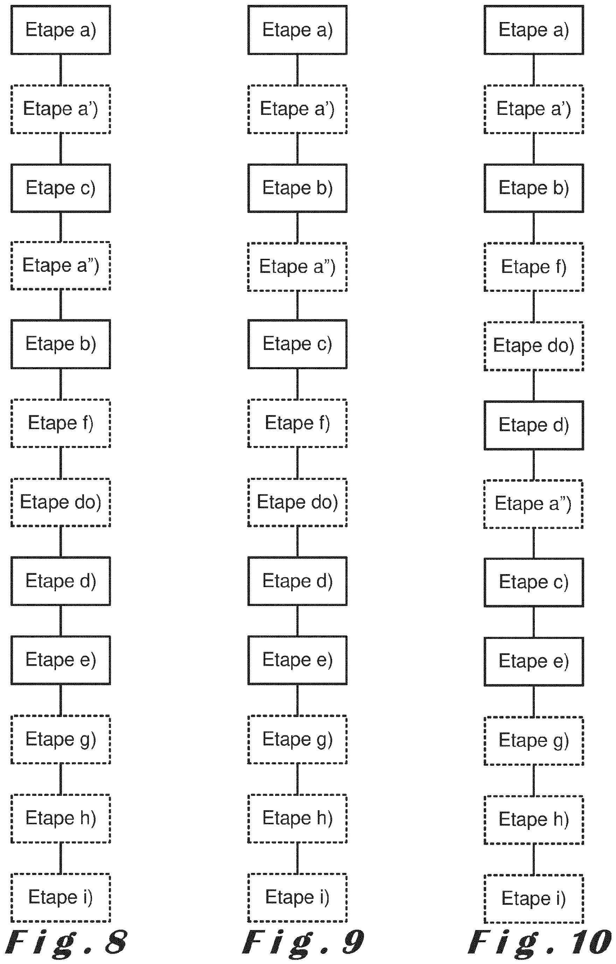

La séquence d'étapes selon ce premier mode de mise en oeuvre est illustrée par la figure 8, sur laquelle les étapes optionnelles sont indiquées en pointillés.

Dans une première étape principale (a) du procédé, illustrée par la figure 1A, on fournit un substrat 1000 de type silicium sur isolant (SOI), qui comprend une première couche de silicium 10 dans laquelle la ou les pièces doivent être formées, une deuxième couche de silicium 20 formant couche de rigidification du substrat et une couche intermédiaire 30 en dioxyde de silicium (SiO₂, aussi appelé communément oxyde de silicium) interposée entre la première et la deuxième couche 10, 20 dans une direction transversale Z du substrat 1000.

Le silicium des première et/ou deuxième couches 10, 20 peut être poly-cristallin mais il est de préférence monocristallin.

Il peut ne pas être dopé ou être dopé, par exemple être dopé au phosphore. Le silicium dopé, électriquement conducteur, est plus stable dimension-nellement et de meilleure résistance mécanique.

De préférence, le silicium des première et/ou deuxième couches 10, 20 est d'orientation {1,1,1}.

Il a avantageusement une résistivité inférieure ou égale à 0,1 Ω.cm, par exemple une résistivité égale à 0,05 Ω.cm.

L'épaisseur e1 de la première couche de silicium 10 dépend de l'épaisseur souhaitée pour les pièces à fabriquer. Elle est typiquement comprise entre 50 microns et 500 microns.

L'épaisseur e2 de la deuxième couche 20 est par exemple comprise entre 300 microns et 800 microns.

La couche intermédiaire 30 forme une couche de liaison entre la première et la deuxième couche 10, 20, et peut également servir de couche d'arrêt lors des opérations de gravure ionique réactive profonde (DRIE) qui seront décrites plus en détail dans la suite. L'épaisseur e3 de la couche intermédiaire est par exemple comprise entre 0,5 microns et 3 microns.

Dans une étape optionnelle (a') illustrée sur la figure 1B, on peut faire croître, à la surface du substrat 1000, une couche de dioxyde de silicium 40.

Cette étape est avantageusement mise en oeuvre lorsque l'épaisseur à graver est importante. La gravure DRIE est typiquement réalisée à travers un masque en résine photosensible qui sera décrit dans la suite du procédé. La résine photosensible est « consommée » lors du procédé et peut parfois ne pas suffire lorsque la profondeur de gravure est importante. L'ajout d'un masque en dioxyde de silicium offre une meilleure sélectivité par rapport à la couche de résine et permet une gravure DRIE plus profonde.

Dans une deuxième étape principale (c) du procédé, on grave une rainure de détachement dans la deuxième couche 20 pour délimiter au sein de cette couche 20 une portion à détacher destinée à recouvrir les pièces qui seront formées ensuite dans la première couche 10.

On peut par exemple définir à l'avance un emplacement prévisionnel des pièces à former dans la première couche. Partant de cet emplacement prévisionnel des pièces, on définit un emplacement de la rainure ou des rainures de détachement tel que chaque rainure de détachement circonscrive au moins une pièce et de préférence un groupe de pièces. Les rainures de détachement sont avantageusement prévues de sorte que toutes les pièces gravées dans la première couche soient recouvertes par une portion à détacher.

L'emplacement de la rainure de détachement peut aussi être choisi pour définir un espace du substrat dans lequel une ou plusieurs pièces pourront être gravées selon les besoins. Le substrat peut ainsi être « préparé » à l'avance, et utilisé pour la fabrication de pièces différentes et/ou réparties indifféremment à l'intérieur dudit espace.

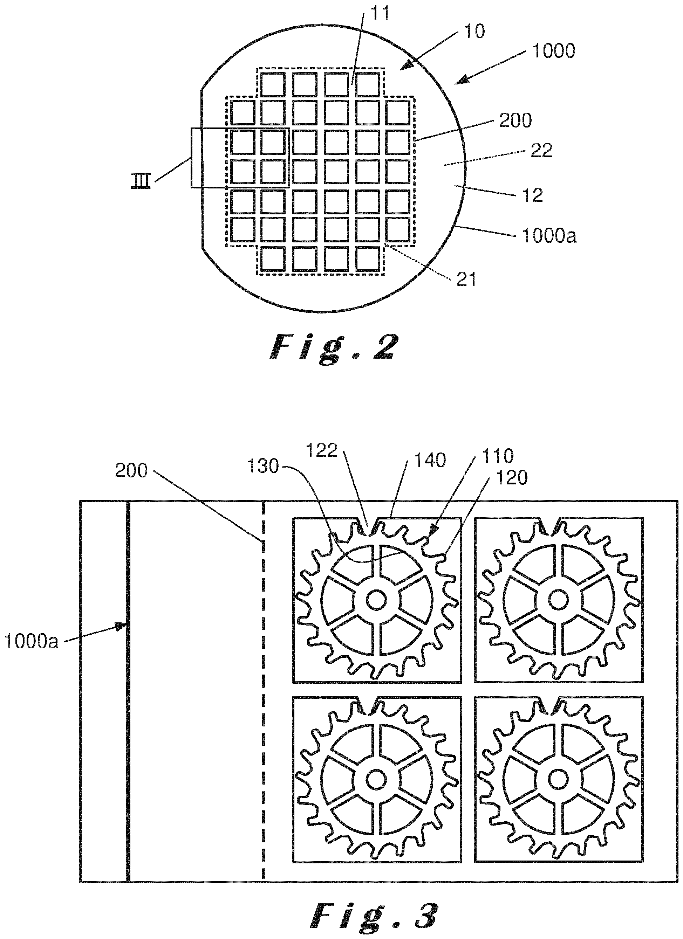

Selon une disposition avantageuse illustrée par la figure 2 notamment, la rainure 200 délimite à elle seule un contour fermé, par exemple en circonscrivant au plus près possible les pièces 110 et/ou en longeant le chant 1000a du substrat en particulier à une distance constante de celui-ci. Comme alternative, la rainure 200 pourrait aussi délimiter un espace fermé avec une portion du chant 1000a du substrat 1000.

Avantageusement, au moins une partie de la portion résiduelle 22 de la deuxième couche 20, située en périphérie de la portion à détacher 21, borde le chant 1000a du substrat 1000.

Pour réaliser la rainure de détachement 200 et comme illustré sur les figures 1C à 1E, on réalise d'abord un masque de gravure 62 sur la deuxième couche 20 du substrat 1000.

Dans une première sous-étape c1), une couche de résine photosensible 60 est déposée sur la deuxième couche 20 du substrat 1000 (figure 1C).

Dans une deuxième sous-étape c2), au moins une ouverture secondaire 61 correspondant au profil souhaité de la rainure de détachement 200 est formée par photolithographie dans la couche de résine 60.

Pour cela, la résine secondaire 60 est exposée à l'aide d'une source lumineuse 81, à travers un photomasque 80 représentant le motif de rainure de détachement souhaité (figure 1D).

Enfin, une partie de la résine 60, correspondant à la portion que l'on souhaite voir attaquer lors de l'opération ultérieure de gravure de la rainure, est éliminée au moyen d'un solvant, formant l'ouverture 61 (figure 1E). Dans le cas d'une résine positive telle qu'illustrée, c'est la portion de la résine exposée à la source lumineuse 81 qui est retirée. Dans le cas d'une résine négative, la portion non-exposée est éliminée.

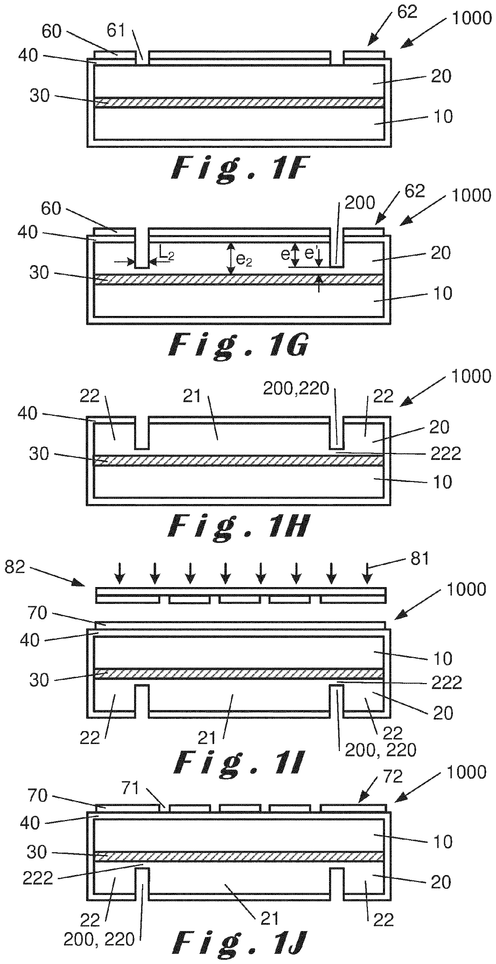

Dans le cas où le substrat 1000 a été recouvert préalablement d'une couche de dioxyde de silicium 40 selon l'étape optionnelle décrite précédemment en lien avec la figure 1B, la couche de dioxyde de silicium 40 est également gravée sous l'ouverture secondaire 61 de la résine, notamment par gravure au plasma (étape c2', figure 1F).

Comme illustré sur la figure 1G, on forme ensuite la rainure de détachement 200 dans la deuxième couche 20 à travers le masque de gravure 62 ainsi réalisé (troisième sous-étape c3).

Pour cela, le silicium de la deuxième couche 20, qui n'est plus protégé par la résine 60 ni par le dioxyde de silicium 40, est gravé par gravure ionique réactive profonde, selon la direction transversale Z, perpendiculaire au plan général du substrat 1000.

La largeur L2 de la rainure 200 correspond sensiblement à la largeur de l'ouverture 61 du masque de résine 62, mais les flancs de la rainure 200 peuvent être légèrement inclinés. Une largeur L2 de la rainure de détachement 200, mesurée orthogonalement à la direction transversale Z, est par exemple inférieure ou égale à 500 microns et de préférence supérieure à 50 microns.

Cette largeur L2 peut être constante ou variable, le long de la rainure de détachement 200, comme il sera décrit plus en détail dans la suite.

Selon l'invention, sur au moins une partie de sa longueur, la rainure de détachement 200 s'étend sur une profondeur e de la deuxième couche 20 inférieure à l'épaisseur e2. Autrement dit, la rainure 200 est gravée pour conserver, au droit de la ou chaque portion dite borgne 220, une partie de la deuxième couche 20 formant un lien 222. Le fond de chaque portion borgne 220 de la rainure 200 est donc constitué par un tel lien 222.

En tout point, le lien 222 a une épaisseur e' sensiblement plus faible que l'épaisseur e2 de la deuxième couche, facilitant sa rupture ultérieure pour la séparation de la portion à détacher 21.

L'épaisseur e', mesurée dans la direction transversale Z, est typiquement supérieure ou égale à 2 microns et de préférence inférieure à 50 microns.

Selon un exemple de réalisation, la rainure de détachement 200 peut être gravée de sorte qu'un lien 222 continu est conservé sur toute la longueur de la rainure 200, comme dans l'exemple illustré. Dans un cas où la rainure de détachement 200 délimite à elle-seule un contour fermé, alors le lien 222 délimite lui-aussi un contour fermé.

La profondeur de la rainure 200 peut être soit constante, soit variable sur la longueur de la rainure de sorte que l'épaisseur e' transversale du lien 222 est elle-aussi variable.

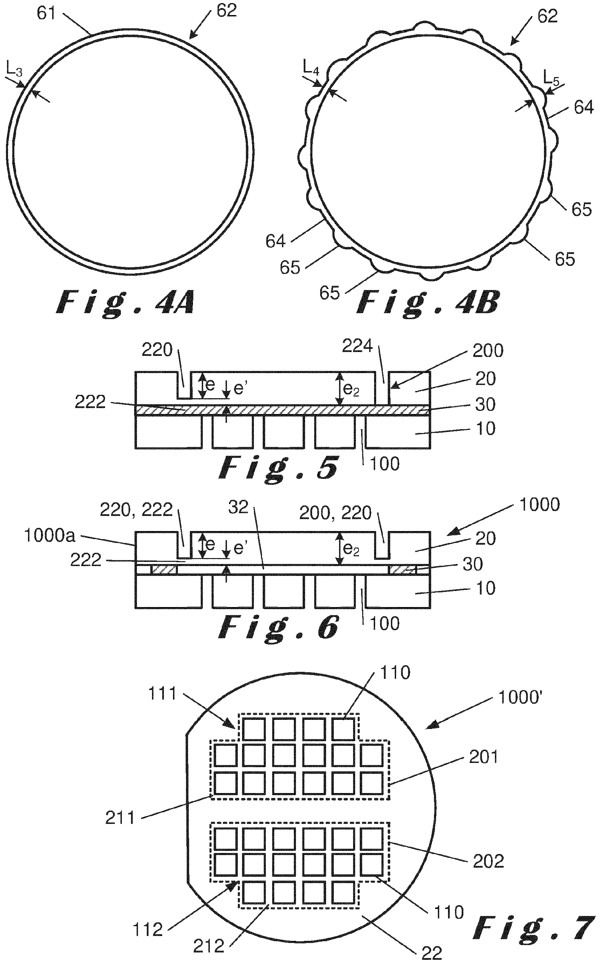

Plus particulièrement, la rainure de détachement 200 peut aussi comporter des portions traversantes 224 sur lesquelles elle traverse toute l'épaisseur e2 de la deuxième couche 20, comme illustré sur la figure 5.

Par exemple, la rainure de détachement 200 peut comporter une alternance de portions traversantes 224 et de portions borgnes 220.

Dans ce cas également, la profondeur de la rainure 200 peut être soit constante soit variable sur une même portion borgne 220 ou sur différentes portions borgnes de la rainure.

Pour obtenir une profondeur variable de la rainure de détachement 200 (qu'elle comporte ou non des portions traversantes 224), il est possible de moduler la largeur L2 de ladite rainure le long de sa longueur. La profondeur de la gravure de type DRIE est en effet dépendante de la largeur de gravure.

La figure 4A illustre une rainure 61 d'un masque de gravure 62 destiné à la réalisation d'une rainure de détachement 200 de profondeur e constante, sur toute sa longueur. La largeur L3 de la rainure 61 du masque est constante.

La figure 4B illustre au contraire une rainure 61 d'un masque de gravure 62 destiné à la réalisation d'une rainure de détachement 200 comportant des portions de profondeurs différentes. La rainure 61 du masque est formée d'une alternance de tronçons primaires 64 de largeur L4 constante et de tronçons secondaires 65 de largeur supérieure à L4, et en particulier de largeur progressivement croissante puis décroissante sur chaque tronçon secondaire 65 avec une largeur maximale L5 sur chaque tronçon secondaire 65. La rainure de détachement 200 gravée à travers un tel masque 62 comportera des portions de profondeur e, au droit des tronçons primaires 64, et des tronçons de profondeur plus importante, supérieure à e, au droit des tronçons secondaires 65.

Par exemple, la rainure de détachement 200 pourra comporter des portions borgnes 220, ayant une première profondeur e, au droit des tronçons primaires 64 du masque, et des portions traversantes 224 au droit des tronçons secondaires 65 du masque 62 (les dites portions 224 s'étendant sur toute ou partie desdits tronçons secondaires 65).

Une rainure de détachement 200 pourvue de portions traversantes 224 présente l'avantage d'être plus facilement détachable, les liens 222, moins rigide, étant plus faciles à briser.

Le procédé se poursuit avec l'élimination de la couche secondaire de résine 60, notamment par nettoyage au plasma d'oxygène (figure 1H).

Puis, dans une troisième étape principale (b) du procédé, on forme les pièces dans la première couche 10 du substrat 1000.

Pour cela, comme illustré par les figures 1I à 1K, on réalise un masque de gravure 72 des pièces sur cette première couche 10 :
Dans une première sous-étape b1), une couche de résine photosensible 70 est déposée sur la première couche 10. Puis, dans une deuxième sous-étape b2), des ouvertures primaires 71 correspondant aux contours des pièces à fabriquer (à l'exception d'une portion de son contour externe destinée à former une attache de la pièce la maintenant au reste du substrat) sont formées dans cette couche de résine, par photolithographie (étape b2). De façon similaire à la mise en oeuvre décrite en lien avec la figure 1B, la résine 70 est pour cela exposée, à travers un photomasque 82 représentant les motifs souhaités, à l'aide d'une source lumineuse 81 (figure 1I). Puis la résine 70 est éliminée localement au moyen d'un solvant pour former les ouvertures 71 du masque (figure 1J).

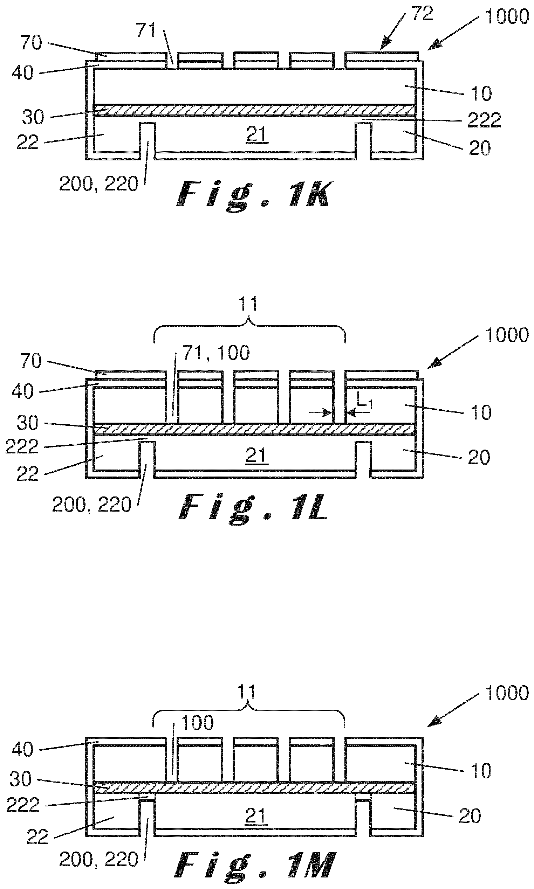

Dans le cas où le substrat 1000 est recouvert d'une couche de dioxyde de silicium 40, cette couche 40 est également gravée sous les ouvertures 71 de la résine 70, notamment par gravure au plasma (figure 1K).

Enfin, comme illustré sur la figure 1L, les pièces à fabriquer 110 sont découpées sur une portion utile 11 de la première couche 10 située en regard de la portion à détacher 21.

Le silicium de la première couche 10, est gravé par gravure ionique réactive profonde (DRIE), à travers les ouvertures 71 du masque 72, selon une direction perpendiculaire au plan général du substrat. La première couche 10 est gravée sur toute son épaisseur e1, la couche intermédiaire 30 formant une couche d'arrêt pour la gravure DRIE.

Les rainures 100 ainsi réalisées peuvent avoir des largeurs L1 différentes ou de préférence une largeur constante par exemple de l'ordre de 50 à 100 microns pour assurer une meilleure verticalité des flancs de gravure.

Comme illustré par la figure 3, pour chaque pièce on grave typiquement au moins une rainure primaire externe 120 correspondant au bord externe de ladite pièce 110 à l'exception d'une portion non gravée appelée attache 122 assurant la liaison entre la pièce et le reste de la première couche 10, et le cas échéant une ou plusieurs rainures primaires internes 130 correspondant aux bords internes de la pièce.

Selon une disposition avantageuse, on grave en outre au moins une rainure primaire périphérique 140 autour des rainures primaires externe 120 et internes 130 de chaque pièce 110, et dont la fonction sera décrite plus en détail dans la suite.

Une fois les pièces gravées, la couche de résine 70 est éliminée, notamment par nettoyage au plasma d'oxygène (figure 1M).

De manière optionnelle, le procédé peut comporter ensuite au moins une étape f) d'oxydation, ou d'oxydation puis désoxydation du substrat 1000 (étape non illustrée). Cette étape est réalisée dans l'atmosphère humide d'un four d'oxydation thermique chauffé à une température avoisinant généralement 1000°C. Lors de l'oxydation, une couche de dioxyde de silicium est formée sur toute la surface externe du substrat 1000, consommant une partie du silicium des première et deuxième couche. En éliminant une épaisseur de dioxyde de silicium par gravure humide ou en phase vapeur lors de la désoxydation, on élimine les défauts de surface et on lisse la surface des pièces à fabriquer. Cette étape f) peut aussi permettre d'ajuster les dimensions de chaque pièce, en mesurant une cote à ajuster sur la pièce. Dans ce cas, l'épaisseur de dioxyde de silicium à former lors de l'oxydation est calculée pour ajuster la cote mesurée à la valeur voulue. Si l'épaisseur calculée nécessite un temps d'oxydation trop long, on peut procéder à plusieurs opérations successives d'oxydation puis désoxydation jusqu'à atteindre la cote souhaitée.

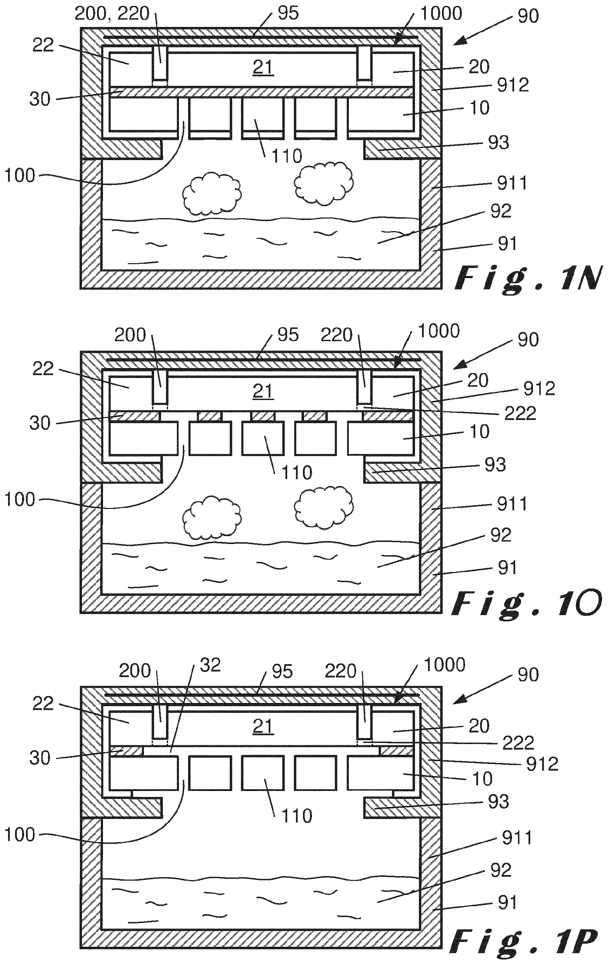

Dans une quatrième étape principale (d) du procédé, illustrée par les figures 1N à 1P, la couche intermédiaire 30 est ensuite partiellement éliminée au droit de la portion à détacher 21.

L'élimination du dioxyde de silicium est par exemple réalisée par gravure chimique, et en particulier par gravure chimique utilisant un agent décapant en phase vapeur, lequel pénètre au moins par les rainures réalisées préalablement dans la première couche.

Cette étape est typiquement réalisée au moyen d'un machine telle qu'illustrée sur la figure 1N comprenant
- une enceinte 91 fermée, formée d'une base 911 et d'un couvercle 912, définissant une cavité dans laquelle peut être logé le substrat 1000, et abritant des moyens de gravure chimique 92, et
- des moyens de maintien 93 du substrat à l'intérieur de ladite enceinte 91.

Les moyens de gravure chimique 92 comprennent, dans l'exemple, un bain d'acide fluorhydrique chauffé, disposé dans la base 911 de l'enceinte 91, et libérant de la vapeur d'acide fluorhydrique.

Dans l'enceinte 91, le substrat 1000 est maintenu à l'horizontale, au-dessus du bain d'acide fluorhydrique, avec, dans l'exemple préféré illustré, sa première couche 10 orientée vers le bas et vers le bain d'acide 92.

Comme alternative, le substrat 1000 pourrait être disposé avec sa première couche 10 orientée vers le haut, mais il faudrait dans ce cas assurer que la vapeur puisse parvenir jusqu'à ladite première couche 10, par exemple en conservant un espace suffisant au-dessus de ladite première couche 10.

Les moyens de maintien 93 comprennent, dans l'exemple, un support horizontal formé sur le couvercle 912 permettant de soutenir le substrat 100, par le dessous, à sa périphérie. Comme alternative ou en complément, les moyens de maintien 93 pourraient aussi comprendre des moyens de maintien électrostatiques et/ou tout autre moyen de maintien adapté.

La machine 90 comprend en outre avantageusement des moyens de chauffage du substrat pour éviter les phénomènes de condensation qui pourraient boucher les rainures primaires 100 et entraver le bon déroulement de la gravure en freinant ou stoppant la vapeur d'acide fluorhydrique.

Ces moyens de chauffage peuvent par exemple prendre la forme d'une plaque chauffante 95 disposée sensiblement à l'horizontale en partie haute de l'enceinte, le substrat 1000 pouvant ainsi être disposé directement contre la surface inférieure de ladite plaque 95, ou contre la surface du couvercle 912 intégrant ou soutenant ladite plaque 95 comme sur la figure 1N.

Pour empêcher la pénétration de l'agent décapant par la rainure 200 (si celle-ci comporte des portions traversantes) et/ou par le bord libre de la couche intermédiaire 30, et retarder ainsi l'élimination de le dioxyde de silicium sous la portion résiduelle 22, il peut en outre être avantageux de mettre en place une protection sur la deuxième couche 20 et/ou sur le chant 1000a du substrat (au moins en regard du bord libre de la couche intermédiaire 30). La protection peut par exemple être une couche de résine résistant à l'agent décapant de la gravure chimique, et/ou un couvercle tel qu'une plaque de recouvrement, le cas échéant munie d'un rebord destiné à coopérer avec le chant du substrat.

Dans l'exemple, la partie supérieure du couvercle 912 forme aussi une protection pour la deuxième couche 20 du substrat, protégeant la rainure de détachement 200 des vapeurs d'acide fluorhydrique.

De façon similaire, la paroi latérale du couvercle 912, en contact avec le chant 1000a du substrat 1000, forme également une protection latérale contre l'agent décapant de la gravure chimique.

La vapeur pénètre ainsi exclusivement par les rainures primaires 100 de la première couche 10 pour grignoter progressivement le dioxyde de silicium sans toutefois attaquer le silicium des première et deuxième couches 10, 20.

Les figures 1O et 1P illustrent l'élimination progressive du dioxyde de silicium de la couche intermédiaire 30, en-dessous puis de part et d'autre de chaque rainure primaire 100 de la première couche 10.

Entre deux flancs de gravure opposés de la première couche 10, les flancs de la couche intermédiaire 30 se rapprochent progressivement (figure 1O) jusqu'à se rejoindre une fois que tout le dioxyde de silicium a été éliminé (figure 1P). Par flancs de gravure opposés, on entend ici des flancs de gravure séparés par une portion continue de silicium de la première couche 10 et alignés dans une direction sensiblement orthogonale à la tangente à l'un des flancs. Si nécessaire et pour accélérer le procédé, on peut ajouter des gravures ou pièces additionnelles dans la première couche 10 en regard de la portion à détacher afin de diminuer la distance entre deux flancs de gravure.

La gravure est arrêtée lorsque la couche intermédiaire 30 est totalement éliminée en regard de la portion à détacher 21 mais avant que toute la couche intermédiaire 30 soit complètement éliminée. En d'autres termes, la gravure est arrêtée de sorte qu'une partie de la couche intermédiaire 30 soit conservée au droit de la portion résiduelle 22 de la deuxième couche 20.

Avantageusement, la gravure chimique est stoppée de sorte que la portion de couche intermédiaire 30 entre la première couche 10 et la portion résiduelle 22 conserve au moins localement une largeur supérieure ou égale à 1mm, laquelle largeur est ainsi suffisante pour assurer l'adhésion entre la portion résiduelle 22 et la première couche 10.

La portion de couche intermédiaire 30 conservée entre la première couche 10 et la portion résiduelle 22 de la deuxième couche 20 est soit continue, soit non-continue mais présente en plusieurs endroits, de préférence répartis sur toute ladite portion résiduelle 22.

Selon l'invention, les pièces 110 formées dans la première couche 10 sont destinées à être libérées par détachement de la portion à détacher 21 délimitée par la rainure de détachement 200.

Lors du détachement, et grâce à la conservation d'une partie de la couche intermédiaire 30, un cadre 50 est formé autour de la portion utile 11 de la première couche portant les pièces 110, ledit cadre 50 étant formé par la superposition d'une partie de la première couche 10 et d'au moins une partie dite résiduelle 22 de la deuxième couche 20, liées par une partie de couche intermédiaire 30.

La figure 6 illustre un substrat 1000 du même type que celui décrit précédemment, à l'issue des étapes b), c) et d), mais sans protection du chant 1000a du substrat (un espace étant conservé entre la paroi latérale de l'enceinte et le chant 1000a du substrat). Dans l'exemple illustré, la rainure de détachement étant borgne sur toute sa longueur, la protection ou non de la deuxième couche 20 du substrat et de la rainure 200 ne fait pas de différence sur le déroulé de l'opération de gravure chimique.

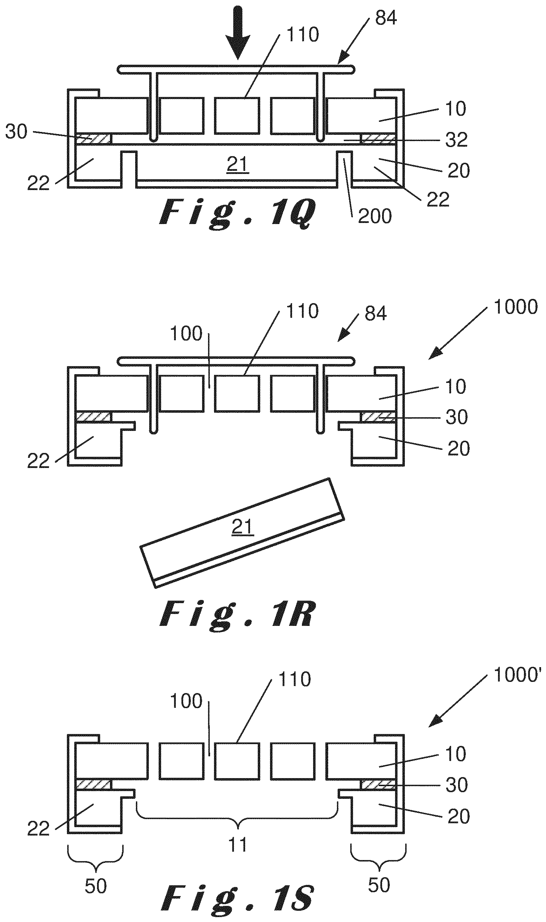

Dans une cinquième étape principale (e) du procédé, illustrée par les figures 1Q et 1R, on sépare mécaniquement la portion à détacher 21 du reste du substrat 1000 en brisant le lien.

Comme illustré par les figures, on pousse par exemple la partie à détacher 21 par l'intermédiaire d'au moins un outil 84 introduit à travers une rainure 100 gravée dans la première couche 10 à l'étape b).

Avantageusement, le procédé peut se poursuivre, à l'issue de cette étape e), avec une ou plusieurs opérations (étape g) d'oxydation, ou d'oxydation et de désoxydation, en vue d'ajuster la raideur ou les dimensions de chaque pièce et/ou avec une étape h) d'oxydation du substrat modifié, à des fins de thermocompensation ou de renforcement mécanique de chaque pièce.

Le substrat modifié 1000`, illustré sur la figure 1S, renforcé par son cadre périphérique 50, ne se déforme pas ou peu au cours de ces traitements ultérieurs ou lorsqu'il est transporté entre ces traitements.

Le procédé peut enfin se terminer par une étape i) de détachement de chaque pièce du substrat modifié 1000', par rupture de son attache 122, facilitée par l'espace de débattement ménagé entre la pièce et la rainure périphérique 140 correspondante.

L'exemple décrit précédemment n'est toutefois pas limitatif et de nombreuses variantes pourront être envisagées.

Ainsi, selon un mode de mise en oeuvre dont un exemple est illustré sur la figure 7, plusieurs rainures de détachement 201, 202 peuvent être formées dans la deuxième couche 20, chacune délimitant à elle-seule ou en combinaison avec le chant 1000a du substrat 1000 une portion à détacher 211, 212 recouvrant une ou plusieurs pièces, de préférence plusieurs pièces.

Selon un exemple, la première couche 10 reste alors d'un seul tenant à l'issue de l'étape de séparation e), et le cadre obtenu est un cadre renforcé entre les différentes portions utiles 111, 112 de la première couche 10, comme sur la figure 7.

Selon un autre mode de réalisation, lors de l'étape b), au moins une rainure de détachement supplémentaire, débouchant à ses deux extrémités sur le chant 1000a du substrat, peut également être réalisée dans la première couche 10, de sorte que la première couche 10 se retrouve divisée en deux ou plus de deux morceaux lors de l'étape de retrait d) ou de séparation e).

Ces deux derniers modes de réalisation peuvent aussi être combinés.

La figure 9 illustre une séquence d'étapes selon un deuxième mode de mise en oeuvre de l'invention. Les étapes en tant que telles sont similaires à celles décrites précédemment mais dans ce cas, les pièces sont gravées en premier dans la première couche du substrat (étape b), puis la ou les rainures de détachement est/sont gravée(s) dans la deuxième couche. Ensuite la couche intermédiaire est partiellement retirée (étape d) puis la portion à détacher est détachée (étape e).

En particulier, les étapes décrites ci-dessus en référence respectivement aux figures 1A, 1B, 1I à 1M, 1à 1H, 1N à 1S peuvent être réalisées dans cet ordre.

Les étapes optionnelles a'), f), g), h), i) sont applicables à ce mode de réalisation également.

La figure 10 illustre une séquence d'étapes selon un troisième mode de mise en oeuvre de l'invention. Les étapes en tant que telles sont similaires à celles décrites précédemment mais dans ce cas, les pièces sont gravées en premier dans la première couche du substrat (étape b), la couche intermédiaire est partiellement retirée (étape d). Puis enfin la ou les rainures de détachement est/sont gravée(s) dans la deuxième couche et la portion à détacher est détachée (étape e). Autrement dit, après formation des pièces, on élimine partiellement le dioxyde de silicium de la couche intermédiaire sur au moins une première zone située en regard de l'emplacement prévisionnel de la portion à détacher, avant de procéder à la gravure de la rainure de détachement. La rainure de détachement est donc gravée en regard d'une zone sur laquelle la couche intermédiaire a d'ores et déjà été éliminée.

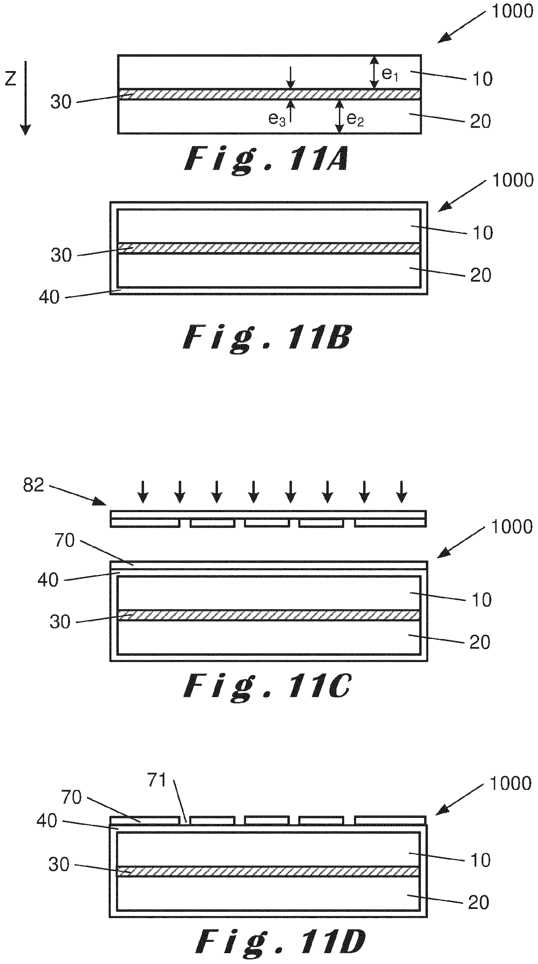

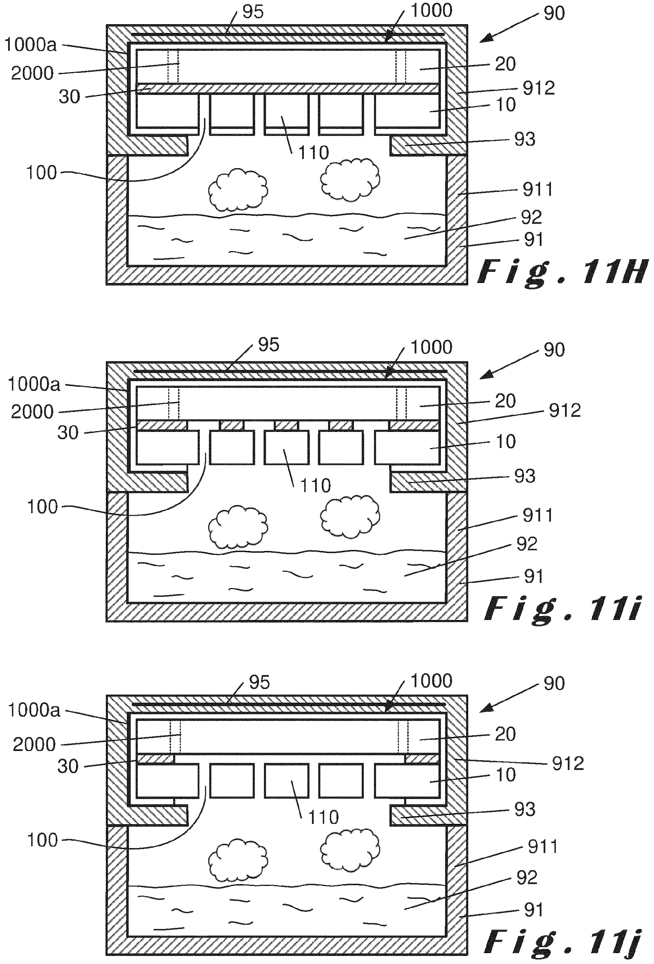

Selon ce troisième mode de mise en oeuvre, plus précisément, on fournit d'abord un substrat 1000 de type silicium sur isolant (SOI), du même type que celui illustré sur la figure 1A (étape a), figure 11A).

Dans une étape optionnelle a') illustrée sur la figure 11B, on peut faire croître, à la surface du substrat 1000, une couche de dioxyde de silicium 40.

Dans une deuxième étape principale (b) du procédé, on forme les pièces 110 dans la première couche 10 du substrat 1000.

Pour cela, comme illustré par les figures 11C à 11E, on réalise un masque de gravure 72 des pièces 110 sur la première couche 10, en déposant une couche de résine photosensible 70 sur la première couche 10 (figure 1C) puis en formant dans cette couche de résine 70 des ouvertures primaires 71 correspondant aux contours des pièces à fabriquer 110 (à l'exception d'une portion de son contour externe destinée à former un lien de la pièce la maintenant au reste du substrat), par photolithographie à travers un photomasque 82 (figure 11C).

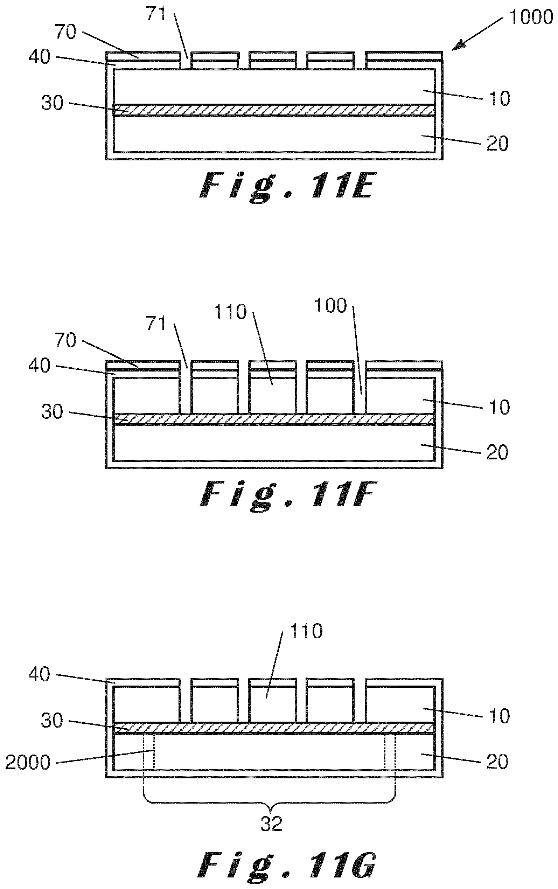

Dans le cas où le substrat est recouvert d'une couche de dioxyde de silicium 40, comme sur les figures, cette couche est gravée sous les ouvertures 71 de la résine 70, notamment par gravure au plasma (figure 11E).

Enfin, comme illustré sur la figure 11F, les pièces à fabriquer 110 sont découpées dans la première couche 10, notamment par gravure DRIE.

Les rainures 100 ainsi réalisées s'étendent sur toute l'épaisseur e1 de la première couche 10, la couche intermédiaire 30 formant une couche d'arrêt pour la gravure DRIE.

De manière optionnelle, le procédé peut comporter ensuite au moins une étape f) d'oxydation, ou d'oxydation puis désoxydation du substrat 1000 (étape non illustrée).

Selon ce mode de réalisation, les pièces 110 ainsi formées seront libérées par retrait de la couche intermédiaire 30 sur une zone sacrificielle 32 (voir figure 11G) leur faisant face, puis détachement d'une portion à détacher 21 de la deuxième couche 20 recouvrant les pièces 110 et elle-même couverte par ladite zone sacrificielle 32, comme décrit dans la suite.

On conserve ainsi un cadre 50 autour d'une portion utile de la première couche portant les pièces 110.

Dans une troisième étape principale (d) du procédé illustrée par les figures 11H à 11J, la couche intermédiaire 30 est donc partiellement éliminée sur une zone recouvrant les pièces formées à l'étape b).

La zone 32 - dite zone sacrificielle de la couche intermédiaire 30 - sur laquelle le dioxyde de silicium est retiré, est une zone dont on peut définir un contour fermé dans un plan parallèle au plan principal du substrat 1000 et intersectant la couche intermédiaire 30.

Une fois l'étape d) terminée, la zone sacrificielle 32, délimitée par son contour fermé, est entièrement vide.

Le contour de la zone sacrificielle 32, projeté transversalement, circonscrit au moins une pièce 110, de préférence une pluralité de pièces 110, notamment comme dans l'exemple illustré la totalité des pièces 110 formées dans la première couche 10.

L'emplacement prévisionnel 2000 de la rainure de détachement 200, qui déterminera la portion à détacher 21 et la portion résiduelle 22 de la deuxième couche 20, peut à ce stade être connu, et l'étape d) peut en particulier être réalisée de sorte que la zone sacrificielle 32 recouvre ledit emplacement prévisionnel 2000.

Selon un autre exemple, l'emplacement de la rainure de détachement pourra être déterminé après l'étape d), en fonction de l'emplacement de la zone sacrificielle 32 formée à cette étape.

L'élimination du dioxyde de silicium peut être réalisée par gravure chimique, et en particulier par gravure chimique utilisant un agent décapant en phase vapeur, dans une machine 90 du même type que celle décrite précédemment en référence aux figures 1N à 1P.

Les figures 11H à 11J illustrent l'élimination progressive du dioxyde de silicium de la couche intermédiaire 30, en-dessous puis de part et d'autre de chaque rainure primaire 100 de la première couche 10.

Dans une quatrième étape principale (c) du procédé, on grave une rainure de détachement 200 dans la deuxième couche 20 pour délimiter au sein de cette couche au moins une portion à détacher 21 recouvrant les pièces formées dans la première couche 10 dans la direction transversale Z et recouverte par la zone sacrificielle 32 de la couche intermédiaire 30 dans la même direction transversale Z.

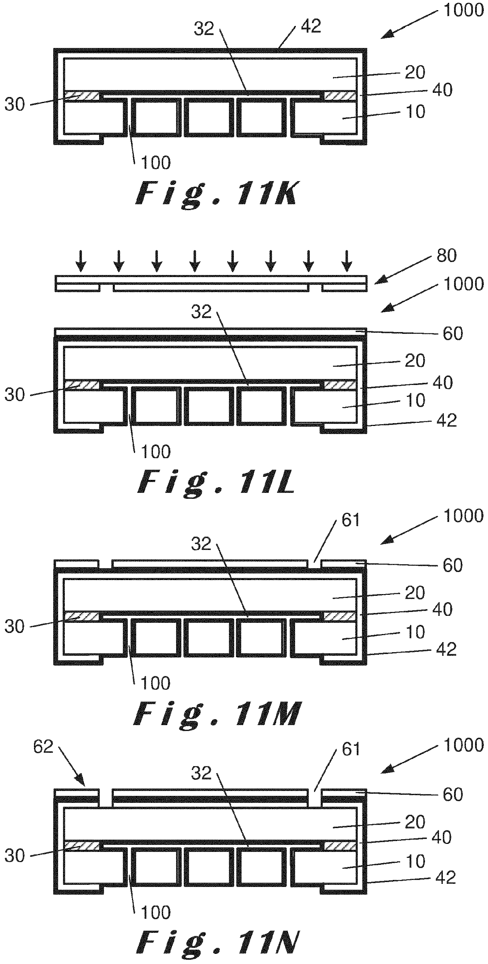

Dans une étape optionnelle a") préalable, illustrée sur la figure 11K, on fait croître, sur l'ensemble du substrat 1000, une couche protectrice de dioxyde de silicium 42, notamment d'épaisseur inférieure à 2 micromètres. L'épaisseur de cette couche protectrice 42 doit être suffisamment faible pour tapisser les surfaces de la première et de la deuxième couche 10, 20 délimitant la zone sacrificielle 32 sans combler à nouveau ladite zone 32. Localement, cette couche 42 peut se superposer à la couche 40 subsistant à la surface du substrat à l'issue de l'étape c) d'élimination partielle de la couche intermédiaire 30 (comme illustré sur la figure 1K par exemple).

Cette couche protectrice 42 est destinée à servir de couche d'arrêt pour la gravure de la rainure de détachement 200 selon la description qui va suivre.

Comme illustré ensuite sur les figures 11L à 11N, on réalise d'abord un masque de gravure 62 de la rainure de détachement 200 sur la deuxième couche 20 du substrat 1000.

Pour cela, une couche de résine photosensible 60 est déposée sur la deuxième couche 20 (figure 11L).

Puis une ouverture secondaire 61 correspondant au profil souhaité de la rainure de détachement 200 est formée par photolithographie dans la couche de résine 60 (figures 11L et 11M), à l'aide d'un photomasque 80 représentant le motif de rainure de détachement 200 souhaité (figure 11L).

Enfin une partie de la résine 60, correspondant à la portion que l'on souhaite voir attaquer lors de l'opération ultérieure de gravure de la rainure 200, est éliminée au moyen d'un solvant, formant l'ouverture 61 (figure 11M).

Dans le cas où le substrat 1000 a été recouvert préalablement d'une couche protectrice de dioxyde de silicium 42 selon l'étape optionnelle décrite précédemment en lien avec la figure 11K, la couche protectrice 42 est également gravée sous l'ouverture secondaire 61 de la résine, notamment par gravure au plasma (figure 11N). La couche 40 issue de l'étape a') (figure 1B) et subsistant en surface de la deuxième couche 20 est, le cas échéant, également gravée.

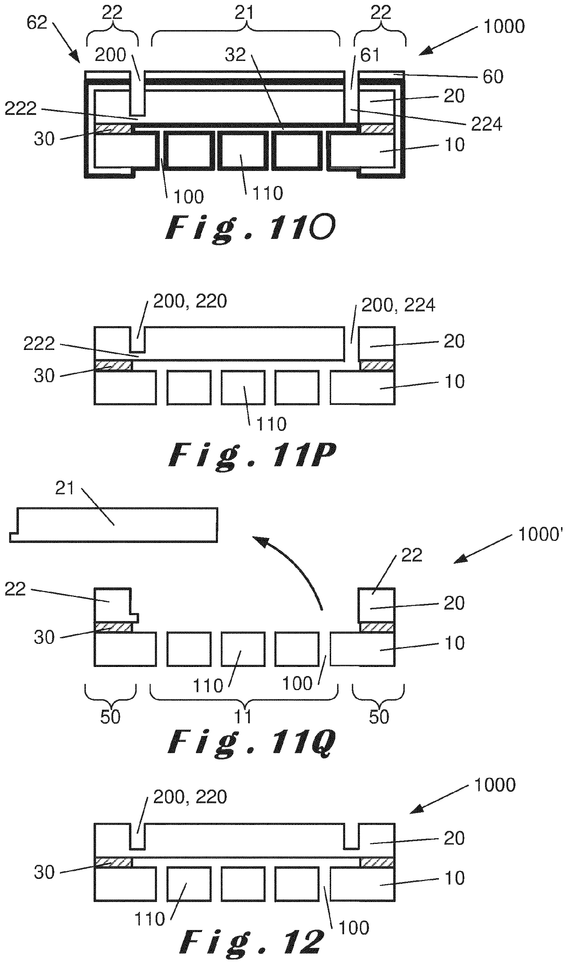

Comme illustré sur la figure 11O, on forme ensuite la rainure de détachement 200 dans la deuxième couche 20 à travers le masque de gravure 62 ainsi réalisé, de sorte à délimiter, au sein de la deuxième couche 20, la portion à détacher 21 recouvrant les pièces 110 formées préalablement dans la première couche 10.

Lors de la gravure DRIE, la couche protectrice 42 déposée comme décrit en référence à la figure 11K forme une couche d'arrêt au droit des portions traversantes 224 de la rainure de détachement 200.

Cette couche protectrice 42 peut être omise dans des cas où la rainure serait borgne sur toute sa longueur, comme illustré sur la figure 12. Dans le cas d'une rainure de détachement au moins partiellement traversante, et en l'absence de couche de protection 42, la gravure de ladite rainure entamerait la première couche 10.

Le procédé se poursuit avec l'élimination de la couche secondaire de résine 60, ainsi éventuellement que la couche protectrice 42 en dioxyde de silicium, et le restant de la couche 40 (figure 11P).

Dans une nouvelle étape e) du procédé, on sépare mécaniquement la portion à détacher 21 du reste du substrat 1000 en brisant la ou les éléments de liaison(s) 222, comme illustré notamment sur la figure 11Q.

Pour cela, on pousse par exemple la partie à détacher 21 par l'intermédiaire d'au moins un outil introduit à travers une rainure 100 gravée dans la première couche 10 à l'étape b).

La partie de la première couche 10, découverte par le retrait de ladite portion 21, et portant les pièces 110, est appelée portion utile 11 de la première couche. Elle est renforcée, à sa périphérie, par le cadre 50.

Avantageusement, le procédé peut se poursuivre, à l'issue de cette étape, avec une ou plusieurs opérations (étape g) d'oxydation et de désoxydation en vue d'ajuster la raideur ou les dimensions de chaque pièce et/ou avec une étape h) d'oxydation du substrat modifié, à des fins de thermocompensation ou de renforcement mécanique de chaque pièce.

Le procédé peut enfin se terminer par une étape i) de détachement de chaque pièce du substrat modifié, par rupture de son attache 122, facilitée par l'espace de débattement ménagé entre la pièce 110 et la rainure périphérique 140 correspondante.

## Revendications

1. Procédé de fabrication d'au moins une pièce (110) en silicium, dans lequel
a) on fournit un substrat (1000) comprenant la superposition, dans une direction transversale (Z), d'au moins une première couche (10) de silicium d'épaisseur e1, une couche intermédiaire (30) de dioxyde de silicium, et une deuxième couche (20) de silicium d'épaisseur e2, la couche intermédiaire (30) étant ainsi interposée entre la première et la deuxième couche (10, 20) ;
puis, dans cet ordre ou un autre :
b) on grave la première couche (10) pour y former l'au moins une pièce (110),
c) dans la deuxième couche (20), on grave au moins une rainure de détachement (200) pour délimiter au sein de ladite deuxième couche (20) au moins une portion à détacher (21) recouvrant ou destinée à recouvrir ladite au moins une pièce (110), au moins une portion dite portion borgne (220) de la rainure de détachement (200) étant gravée de sorte qu'une partie (222) de la deuxième couche (20), formant lien, soit conservée au droit de ladite portion (220), et
d) on retire partiellement la couche intermédiaire (30) en éliminant le dioxyde de silicium au droit de ladite au moins une portion à détacher (21) ou de l'emplacement prévisionnel de ladite portion à détacher (21) ;
et enfin
e) on sépare mécaniquement l'au moins une portion à détacher (21) du reste du substrat en brisant le lien (222).

2. Procédé selon la revendication 1, dans lequel lors de l'étape e), on pousse la partie à détacher (21) par l'intermédiaire d'au moins un outil (84) introduit à travers une rainure (100) gravée dans la première couche (10) à l'étape b).

3. Procédé selon la revendication 1 ou 2, dans lequel l'épaisseur (e') d'un lien (222), mesurée dans la direction transversale (Z), est égale à au moins 2 microns.

4. Procédé selon l'une quelconque des revendications 1 à 3, dans lequel la rainure de détachement (200) délimite, à elle seule ou conjointement avec un chant du substrat (1000a), un contour fermé.

5. Procédé selon quelconque l'une des revendications 1 à 4, dans lequel la rainure de détachement (200) a une profondeur qui varie sur sa longueur.

6. Procédé selon l'une quelconque des revendications 1 à 5, dans lequel la rainure de détachement (200) comporte en outre au moins une portion traversante (224) sur laquelle elle traverse toute l'épaisseur e2 de la deuxième couche (20).

7. Procédé selon la revendication 6, dans lequel la rainure de détachement (200) comporte une alternance de portions traversantes (224) sur lesquelles elle traverse toute l'épaisseur e2 de la deuxième couche (20) et de portions borgnes (220).

8. Procédé selon quelconque l'une des revendications 1 à 5, dans lequel la rainure de détachement (200) est gravée de sorte qu'une partie (222) de la deuxième couche (20), formant lien, soit conservée au droit de ladite rainure (200) sur toute sa longueur.

9. Procédé selon quelconque l'une des revendications 1 à 8, dans lequel on grave une pluralité de pièces (110) dans la première couche (10), et au moins une rainure de détachement (200) délimite une portion à détacher (21) recouvrant ou destinée à recouvrir ladite pluralité de pièces (110).

10. Procédé selon l'une quelconque des revendications 1 à 9, dans lequel les étapes b), c), d) sont réalisées dans cet ordre.

11. Procédé selon l'une quelconque des revendications 1 à 9, dans lequel les étapes c), b), d) sont réalisées dans cet ordre.

12. Procédé selon l'une quelconque des revendications 1 à 9, dans lequel les étapes b), d), c) sont réalisées dans cet ordre.

13. Procédé selon l'une quelconque des revendications 1 à 12, dans lequel à l'étape d), on conserve une partie de la couche intermédiaire (30) en regard d'au moins une portion résiduelle (22) de la deuxième couche (20) située hors d'une portion à détacher (21) ou d'un emplacement prévisionnel d'une telle portion à détacher (21).

14. Procédé selon l'une quelconque des revendications 1 à 13, dans lequel une largeur de la rainure de détachement (200), mesurée orthogonalement à la direction transversale (Z), est inférieure ou égale à 500 microns.

## Patentansprüche

1. Verfahren zur Herstellung von mindestens einem Siliziumbauteil (110), in welchem
a) ein Substrat (1000) bereitgestellt wird, umfassend die Überlagerung in einer transversalen Richtung (Z) von mindestens einer ersten Schicht (10) aus Silizium mit einer Dicke e1, einer Zwischenschicht (30) aus Siliziumdioxid, und einer zweiten Schicht (20) aus Silizium mit einer Dicke e2, wobei die Zwischenschicht (30) somit zwischen der ersten und der zweiten Schicht (10, 20) eingefügt ist;
dann, in dieser oder einer anderen Reihenfolge:
b) die erste Schicht (10) graviert wird, um dort mindestens ein Bauteil (110) zu formen,
c) in die zweite Schicht (20) mindestens eine Trennnut (200) graviert wird, zur Begrenzung innerhalb der besagten zweiten Schicht (20) von mindestens einem zu trennenden Teil (21), der das besagte mindestens eine Bauteil (110) bedeckt oder dazu bestimmt ist es zu bedecken, wobei mindestens ein Teil, genannt Sacklochteil (220) der Trennnut (200) so graviert wird, dass ein Bestandteil (222) der zweiten Schicht (20), die Verbindung bildend, an dem besagten Teil (220) beibehalten wird, und
d) die Zwischenschicht (30) teilweise abgetragen wird, indem das Siliziumdioxid an dem besagten mindestens einen zu trennenden Teil (21) oder der vorläufigen Position des besagten zu trennenden Teils (21) entfernt wird;
und schliesslich
e) mindestens ein zu trennender Teil (21) vom Rest des Substrats mechanisch getrennt wird, indem die Verbindung (222) gebrochen wird.

2. Verfahren nach Anspruch 1, in welchem während des Schritts e) der zu trennende Teil (21) mit Hilfe von mindestens einem Werkzeug (84), eingeführt über eine im Schritt b) in die erste Schicht (10) gravierte Nut (100), geschoben wird.

3. Verfahren nach Anspruch 1 oder 2, in welchem die Dicke (e') einer Verbindung (222), gemessen in transversaler Richtung (Z), mindestens 2 Mikrometer beträgt.

4. Verfahren nach einem der Ansprüche 1 bis 3, in welchem die Trennnut (200) allein oder zusammen mit einer Schmalseite des Substrats (1000a) eine geschlossene Kontur begrenzt.

5. Verfahren nach einem der Ansprüche 1 bis 4, in welchem die Trennnut (200) eine Tiefe hat, die entlang ihrer Länge variiert.

6. Verfahren nach einem der Ansprüche 1 bis 5, in welchem die Trennnut (200) des Weiteren mindestens einen hindurchgehenden Teil (224) umfasst, über den sie die gesamte Dicke e2 der zweiten Schicht (20) durchläuft.

7. Verfahren nach Anspruch 6, in welchem die Trennnut (200) eine Wechselfolge von hindurchgehenden Teilen (224), über die sie die gesamte Dicke e2 der zweiten Schicht (20) durchläuft, und von Sacklochteilen (220), umfasst.

8. Verfahren nach einem der Ansprüche 1 bis 5, in welchem die Trennnut (200) so graviert ist, dass ein Bestandteil (222) der zweiten Schicht (20), die Verbindung bildend, an der besagten Nut (200) entlang ihrer gesamten Länge beibehalten wird.

9. Verfahren nach einem der Ansprüche 1 bis 8, in welchem eine Vielzahl von Bauteilen (110) in die erste Schicht (10) graviert wird, und mindestens eine Trennnut (200) einen zu trennenden Teil (21) begrenzt, der die besagte Vielzahl von Bauteilen (110) bedeckt oder dazu bestimmt ist, sie zu bedecken.

10. Verfahren nach einem der Ansprüche 1 bis 9, in welchem die Schritte b), c), d) in dieser Reihenfolge durchgeführt werden.

11. Verfahren nach einem der Ansprüche 1 bis 9, in welchem die Schritte c), b), d) in dieser Reihenfolge durchgeführt werden.

12. Verfahren nach einem der Ansprüche 1 bis 9, in welchem die Schritte b), d), c) in dieser Reihenfolge durchgeführt werden.

13. Verfahren nach einem der Ansprüche 1 bis 12, in welchem im Schritt d) ein Teil der Zwischenschicht (30) in Bezug auf mindestens einen verbleibenden Teil (22) der zweiten Schicht (20), die ausserhalb eines zu trennenden Teils (21) oder einer vorläufigen Position eines solchen zu trennenden Teils (21) liegt, beibehalten wird.

14. Verfahren nach einem der Ansprüche 1 bis 13, in welchem eine Breite der Trennnut (200), rechtwinklig zu der transversalen Richtung (Z) gemessen, weniger oder gleich 500 Mikrometer beträgt.

## Claims

1. Method for manufacturing at least one part in silicon wherein
a) a substrate (1000) is provided comprising the superposition, in a transverse direction (Z), of at least a first layer (10) of silicon of thickness e1, an intermediate layer (30) of silicon dioxide, and a second layer (20) of silicon of thickness e2, the intermediate layer (30) thus being interposed between the first and second layers (10, 20);
then, in this order or another:
b) the first layer (10) is etched to form the at least one part (110),
c) at least one detachment groove (200) is etched in the second layer (20) to delimit within said second layer (20) at least one portion to be detached (21) covering or intended to cover said at least one part (110), at least one so-called blind portion (220) of the detachment groove (200) being etched in such a way that a part (222) of the second layer (20), forming a connection, is retained in line with said portion (220), and
d) the intermediate layer (30) is partially removed by eliminating the silicon dioxide in line with the said at least one portion to be detached (21) or the intended location of the said portion to be detached (21);
and finally
e) the at least one portion to be detached (21) is mechanically separated from the rest of the substrate by breaking the connection (222).

2. Method according to claim 1, wherein in step e), the part (21) to be detached is pushed by means of at least one tool (84) inserted through a groove (100) etched in the first layer (10) in step b).

3. Method according to claim 1 or 2, wherein the thickness (e') of a connection (222), measured in the transverse direction (Z), is at least 2 microns.

4. Method according to any one of the claims 1 to 3, wherein the detachment groove (200), alone or together with an edge of the substrate (1000a), defines a closed contour.

5. Method according to any one of the claims 1 to 4, wherein the detachment groove (200) has a depth which varies along its length.

6. Method according to any one of the claims 1 to 5, wherein the detachment groove (200) further comprises at least one through portion (224) over which it passes through the entire thickness e2 of the second layer (20).

7. Method according to claim 6, wherein the detachment groove (200) comprises an alternation of through portions (224) on which it passes through the entire thickness e2 of the second layer (20) and blind portions (220).

8. Method according to any one of the claims 1 to 5, wherein the detachment groove (200) is engraved in such a way that a part (222) of the second layer (20), forming a connection, is retained in line with the said groove (200) over its entire length.

9. Method according to any one of the claims 1 to 8, wherein a plurality of parts (110) is etched in the first layer (10), and at least one detachment groove (200) delimits a portion to be detached (21) covering or intended to cover said plurality of parts (110).

10. Method according to any one of the claims 1 to 9, wherein the steps b), c), d) are carried out in this order.

11. Method according to any one of the claims 1 to 9, wherein the steps c), b), d) are carried out in this order.

12. Method according to any one of the claims 1 to 9, wherein the steps b), d), c) are carried out in this order.

13. Method according to any one of the claims 1 to 12, wherein in step d), part of the intermediate layer (30) is kept opposite at least one residual portion (22) of the second layer (20) located outside a portion to be detached (21) or a planned location of such a portion to be detached (21).

14. Method according to any one of the claims 1 to 13, wherein a width of the detachment groove (200), measured orthogonally to the transverse direction (Z), is less than or equal to 500 microns.
